# EUROPÄISCHE PATENTSCHRIFT

(11) **EP 0 443 378 B1**
(45) Veröffentlichungstag und Bekanntmachung des Hinweises auf die Patenterteilung: **28.12.1994**
(21) Anmeldenummer: 91101724.2
(22) Anmeldetag: 08.02.1991
(51) Int. Cl.: H05K 7/20, H02M 7/00

(54) **Elektronischer Leistungsschalter**
Electronic power switch
Commutateur électronique de puissance

(30) Priorität: 20.02.1990 DE 4005333
(43) Veröffentlichungstag der Anmeldung: 28.08.1991
(73) Patentinhaber: R e h m Schweisstechnik GmbH u. Co., 73066 Uhingen (DE)
(72) Erfinder: Schuster, Wolfgang, W-7300 Esslingen (DE)
(74) Vertreter: Aldag, Wolfgang, Dipl.-Ing.

(56) Entgegenhaltungen:
- EP-A- 0 249 725
- DE-A- 3 144 579
- DE-A- 3 320 575
- DE-U- 8 508 595
- DE-U- 9 012 147
- FR-A- 2 410 416
- GB-A- 2 214 731
- US-A- 4 376 250
- ELECTRONIQUE INDUSTRIELLE Nr. 27. Februar 1982, PARIS FR Seiten 23 - 29;'Transistors de commutation des composants mieux adaptés'

## Beschreibung

Die Erfindung betrifft einen elektronischen Leistungs-Schalter in Halbbrückenschaltung, der zwischen zwei Gleichspannungsanschlüssen eine Reihenschaltung von zwei Ventilgruppen besitzt, und bei dem wenigstens eine Ventilgruppe aus einer Parallelschaltung von mehreren einzelnen gleichartigen Ventilen geringer Strombelastbarkeit besteht, bei dem alle Ventile beider Gruppen auf einer gemeinsamen Leiterplatte befestigt sind und bei dem die Ventile im Schaltbetrieb eingesetzt werden.

Ein elektronischer Leistungsschalter dieser Art ist aus der DE 36 20 074 A1 bekannt. Derartige, als Halbbrückenschaltung ausgelegte elektronische Leistungs-Schalter werden in der Elektrotechnik häufig verwendet. Im vorliegenden Anwendungsfall soll die Betrachtung auf den reinen Schaltbetrieb und für größere Leistungen beschränkt werden. Darunter sei der Fall verstanden, daß die Strombelastbarkeit marktüblicher Halbleiter-Bauelemente allein nicht mehr ausreicht, so daß eine Parallelschaltung mehrerer gleichartiger Halbleiterbauelemente erforderlich wird, also für schaltbare Leistung > als 1 KW.

Dies tritt z.B. bei Schweißmaschinen auf, deren Ausgangsstrom einige hundert Ampère betragen kann. Bei Gleichstrom-Schweißmaschinen wird oft mit einem Transistorchopper - also einer Halbbrückenschaltung mit einer Transistor- und einer Diodengruppe - mit Hilfe einer Glättungsdrossel eine Stromregelung durchgeführt, üblicherweise mit Frequenzen, welche über dem Hörbereich liegen.

Dadurch wird der Einsatz sehr schnell schaltender Halbleiterbauelemente nötig, welche dann im Mikro-, ja sogar im Nanosekunden-Bereich Ströme von mehreren hundert Ampère schalten müssen.

Beim Aufbau solcher Schaltungen gewinnt die mechanische Anordnung unter dem Gesichtspunkt geringster Streuinduktivitäten eine alles entscheidende Bedeutung, da sonst die Sperrspannungsbeanspruchung oder die Schaltverlustleistung der Halbleiterbauelemente zu groß wird. Da die einzelnen Halbleiterbauelemente oft auf getrennten Kühlblechen befestigt sind, ergeben sich große Streuinduktivitäten. Daher müssen zusätzliche Bedampfungsglieder, wie Stützkondensatoren, eingesetzt werden, die das Bauvolumen vergrößern.

Benötigt man für Wechselstrom-Schweißmaschinen auf der Sekundärseite eine komplette Transistor-Vollbrücke, also einen Inverter, mit vier steuerbaren Halbleiterbauelementen, so wird das Gesamtvolumen in der bisherigen Bauart derart groß, daß sich eine wirtschaftliche Anwendung nicht erreichen läßt. So hat sich in der Schweißtechnik dieses zunächst naheliegende Prinzip mit selbstgeführtem Sekundär-Inverter in Transistortechnik bisher nicht durchsetzen können.

Die Probleme liegen also im bisher benötigten Bauvolumen, in der noch zu hohen Streuinduktivität des bekannten Aufbaus und in der sehr lohnintensiven und aufwendigen Montage mit zu vielen Stromschienen, Kühlkörpern, Kondensatoren und Befestigungsmitteln und damit in einem zu hohen Preis.

Wie die DE 33 20 575 A1, die DE 31 44 579 A1 und die DE 85 08 595 U1 zeigen, ist es bekannt, Ventilgruppen parallel zu schalten, sowie mehrere Ventilgruppen in Reihe zu schalten. Als Ventil lassen sich Dioden, Transistoren, Thyristoren oder andere Leistungs-Halbleiterbauelemente verwenden. Die Ansteuerschaltkreise und eventuelle Versorgungs- und Kontrollschaltkreise können dabei neben den Ventilen auf derselben Leiterplatte befestigt werden.

Eine Kühlschiene mit Rippen zu versehen, ist aus der DE 38 02 593 A1 bekannt. Und die DE 27 53 145 zeigt, daß die Kühlschiene mittels eines Kühlmittels gekühlt werden kann.

Es ist Aufgabe der Erfindung, eine Halbbrückenschaltung der eingangs erwähnten Art für Hochstromanwendungen zu schaffen, die den bisherigen Volumenbedarf auf etwa 1/3 reduziert und wenig Streuinduktivität besitzt, so daß die Bedämpfungsglieder entfallen können. Durch eine gute Integration von Mechanik und Elektronik soll der elektronische Leistungs-Schalter darüber hinaus kostengünstiger herstellbar sein.

Diese Aufgabe wird nach der Erfindung auf zwei gleichwertige Arten gelöst. Zum einen kann der konstruktive Aufbau so sein, daß die ersten und die zweiten, parallel geschalteten Ventile jeweils nebeneinander in einer Reihe an einer gemeinsamen Kühlschiene befestigt sind, wobei die ersten Ventile elektrisch isoliert und die zweiten Ventile elektrisch leitend mit der Kühlschiene verbunden sind, daß die Kühlschiene den Mittelanschluß zwischen den ersten und den zweiten Ventilen bildet, daß der gesamte Laststrom über die Kupferlage(n) der Leiterplatte geführt ist und daß eine Leiterschleife aus den ersten Ventilen, den zweiten Ventilen und den Stützkondensatoren real nur aus den diskreten Bauteilen mit ihren Anschlußdrähten, den Kupferlagen der Leiterplatte und der gemeinsamen Kühlschiene besteht, während die andere Ausgestaltung vorsieht, daß die ersten parallel geschalteten Ventile nebeneinander in einer Reihe an einer gemeinsamen ersten Kühlschiene befestigt sind und die zweiten parallel geschalteten Ventile ebenfalls linear nebeneinander an einer gemeinsamen zweiten Kühlschiene elektrisch leitend befestigt sind, daß die elektrisch leitende zweite Kühlschiene den Mittelanschluß zwischen den ersten und den zweiten Ventilen bildet, daß der gesamte Laststrom über die Kupferlage(n) der Leiterplatte geführt ist, und daß eine Leiterschleife aus den ersten Ventilen, den zweiten Ventilen und den Stützkondensatoren real nur aus den diskreten Bauteilen mit ihren Anschlußdrähten, den Kupferlagen der Leiterplatte und den Kühlschienen mit ihren Befestigungsmitteln besteht.

In jedem Falle wird ein Schaltungsaufbau mit deutlich reduzierten Streuinduktivitäten erreicht und die Kühlschienen bzw. die gemeinsame Kühlschiene führen die Wärme von den Halbleiterbauelementen ab und dienen gleichzeitig als Bestandteile bzw. Bestandteil der Leiterschleife der Halbbrückenschaltung.

Wird eine gemeinsame Kühlschiene für alle Ventile verwendet, dann ist zur Realisierung der Halbbrückenschaltung erforderlich, daß die ersten Ventile elektrisch isoliert und die zweiten Ventile jeweils mit einem Anschluß elektrisch leitend mit der zugeordneten Kühlschiene verbunden sind. Dabei kann zur Verbesserung der Wärmeabfuhr zudem vorgesehen sein, daß die gemeinsame Kühlschiene selbst als Kühlkörper ausgebildet ist.

Bei der Verwendung von zwei Kühlschienen kann die Wärmeabfuhr dadurch verbessert werden, daß die beiden Kühlschienen elektrisch isoliert, jedoch wärmeleitend mit einem weiteren Kühlkörper verbunden sind, der mit den beiden parallel und im Abstand zueinander auf der Leiterplatte befestigten Kühlschienen in Verbindung steht. Dabei kann zudem vorgesehen sein, daß die Leiterplatte nur eine Kupferlage aufweist und daß die elektrisch leitenden Befestigungsmittel die Kühlschienen mit der Leiterplatte verbinden und daß zwischen den beiden Kühlschienen die Stützkondensatoren angeordnet sind.

Als Ventile lassen sich Dioden, Transistoren, Thyristoren oder andere Leistungs-Halbleiterbauelemente sowie Kombinationen derselben einsetzen.

Nach einer weiteren Ausgestaltung ist vorgesehen, daß auf der Leiterplatte den Ventilen benachbart die Ansteuerschaltkreise und erforderlichenfalls Versorgungs- bzw. Kontrollschaltkreise zur Beeinflussung bzw. Kontrolle der Ventile aufgebracht sind. Damit lassen sich auch im Bereich der Ansteuerung der Ventile lange Leitungswege vermeiden.

Die Erfindung wird anhand von in den Zeichnungen dargestellten Ausführungsbeispielen näher erläutert. Es zeigt:
- Fig. 1: den prinzipiellen Aufbau einer Halbbrückenschaltung,
- Fig. 2: den tatsächlichen Aufbau der Halbbrückenschaltung im Schnitt,
- Fig. 3: ein erstes Ausführungsbeispiel eines konstruktiven Aufbaues der Halbbrückenschaltung,
- Fig. 4: ein zweites Ausführungsbeispiel eines konstruktiven Aufbaues der Halbbrückenschaltung und
- Fig. 5 und 6: in zwei Ansichten den Verlauf der Leiterschleife bei Verwendung einer einseitig mit Leiterbahnen versehenen Leiterplatte.

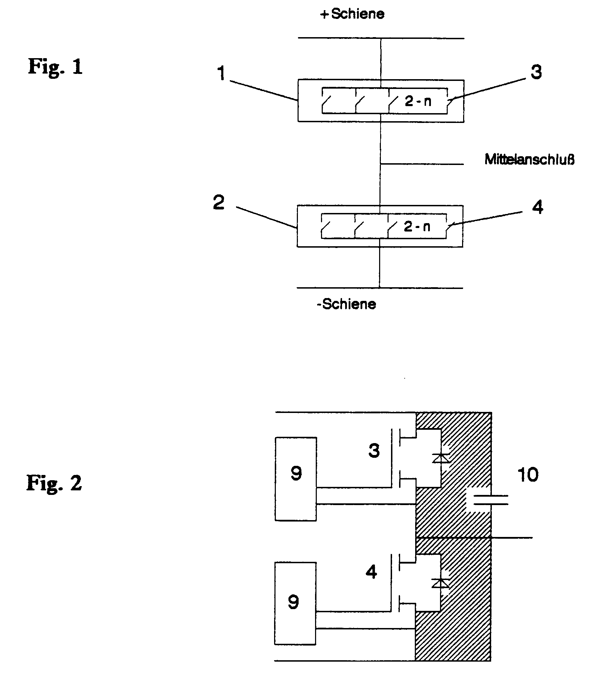

Fig. 1 zeigt die prinzipielle Anordnung einer Halbbrückenschaltung. Zwischen den beiden Spannungsanschlüssen liegen die zwei Ventilgruppen 1 und 2 in Reihe, so daß der gemeinsame Mittelanschluß im Schaltbetrieb einmal annähernd das Potential der + Schiene oder im anderen Falle das Potential der -Schiene führen kann. Es ist weiter gezeigt, daß die Ventilgruppen sich aus mehreren einzelnen Ventilen 3 und 4 zusammensetzen können.

Fig. 2 zeigt eine reale Ausführung einer Halbbrückenschaltung mit zwei einzelnen MOS-FET-Transistoren, welche für die Parallelanordnung aller Einzelventile stehen sollen. Diese enthalten durch ihren Aufbau bedingt bereits eine invers gepolte Diode, welche als sogenannte Freilaufdiode in den meisten Halbbrückenschaltungen ohnehin benötigt wird. Gezeigt ist weiter, daß die Transistoren zwei Ansteuerschaltkreise 9 benötigen, deren Ausführung nicht Gegenstand dieser Erfindung ist und mit bekannten Mitteln erfolgt. Weiterhin ist ein Stützkondensator 10 zwischen den Spannungsschienen eingezeichnet. Dieser verhindert beim Schalten von stark induktiven Lasten, daß die Transistoren mit Überspannungsspitzen belastet werden. Die schraffierte Fläche in Fig. 2 bildet beim realen Aufbau eine Leiterschleife mit einer meßbaren Induktivität. Beim Schalten der Transistoren entsteht in dieser Streuinduktivität eine Spannung von U = L · di/dt.

Da man mit parallel geschalteten MOS-FETs Ströme von 200A in Zeiten von z.B. 100ns schalten kann, entsteht also pro Nano-Henry Streuinduktivität eine Überspannung von 2V. Der ganze Aufbau darf also nur wenige Nano-Henry Streuinduktivität aufweisen, wenn die preiswerten Niederspannungstypen der MOS-FETs zum Einsatz kommen sollen und z.B. nur wenige Volt Spielraum für Spikes gegeben wird. Dieses Problem der Streuinduktivität ist der Schlüssel zur Lösung der Aufgabe. Da gleichzeitig niedrige Fertigungskosten angestrebt werden, muß eine Anordnung gefunden werden, welche es erlauben, die Leiterplatten möglichst mit einem Automaten bestücken und sie komplett auf einer automatischen Lötanlage löten zu können. Durch eine lineare Anordnung der Ventile in zwei parallel zueinander liegenden Reihen wurde eine Grundstruktur erreicht, welche bei gleich stark belasteten Ventilen folgende Vorteile besitzt:

Die Kühlfläche vergrößert sich linear mit der Zahl der parallel geschalteten Ventile, denn der Kühlkörper wird länger.

Die Stromdichte in den Kupferbahnen der Leiterplatte ist nahezu unabhängig von der Anzahl der Ventile, da der Strom quer zur Richtung der Kühlkörper fließt und mit jedem zusätzlichen Ventil zusätzliche Kupferfläche dazukommt.

Die Streuinduktivität pro Ampère Laststrom bleibt unabhängig von der Anzahl der Ventile, da mit jedem zusätzlichen Ventil die Breite der Kupferbahnen anwächst und so die Induktivität abnimmt.

Dadurch ist eine sehr variable und in hohe Strombereiche ausbaufähige Grundstruktur angelegt.

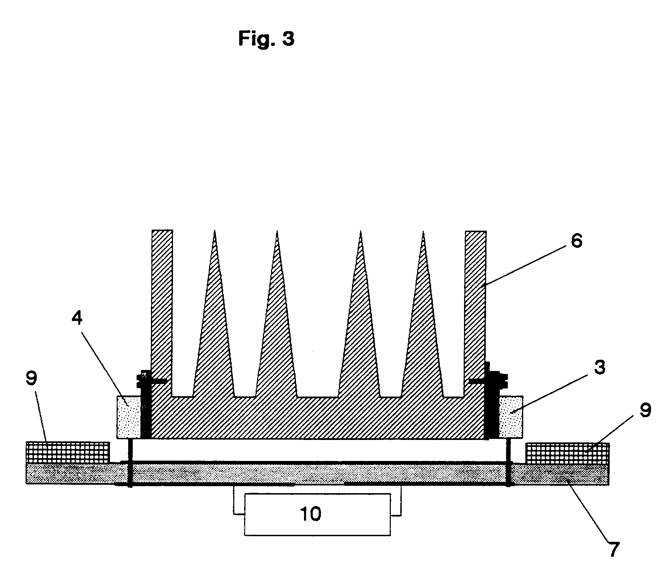

Fig. 3 zeigt eine mögliche Ausführung mit einer zweilagigen Leiterplatte 7 und einer gemeinsamen Kühlschiene 6. An einer Längsseite dieses normalerweise aus Aluminium bestehenden Profiles sind die parallel geschalteten Ventile 4 nebeneinander elektrisch leitend montiert, auf der anderen Seite ist die Reihe der Ventile 3 mit bekannten Mitteln elektrisch isoliert befestigt. Das Profil besitzt einen großen Querschnitt und dient als Anschluß für die Mittelanzapfung der Halbbrücke. Die elektrische Verbindung der ersten Ventilgruppe, gebildet aus den Ventilen 3 mit der zweiten Ventilgruppe, gebildet aus den Ventilen 4 geschieht durch die Kupferauflage der Leiterplatte. Die Stützkondensatoren 10 liegen bei dieser Ausführung entweder auf der Unterseite der Leiterplatte 7 oder besser auf der Oberseite in einer Aussparung der Kühlschiene. Seitlich der Leiterplatte 7 ist Raum für die Ansteuer-und Kontroll-Schaltkreise 9.

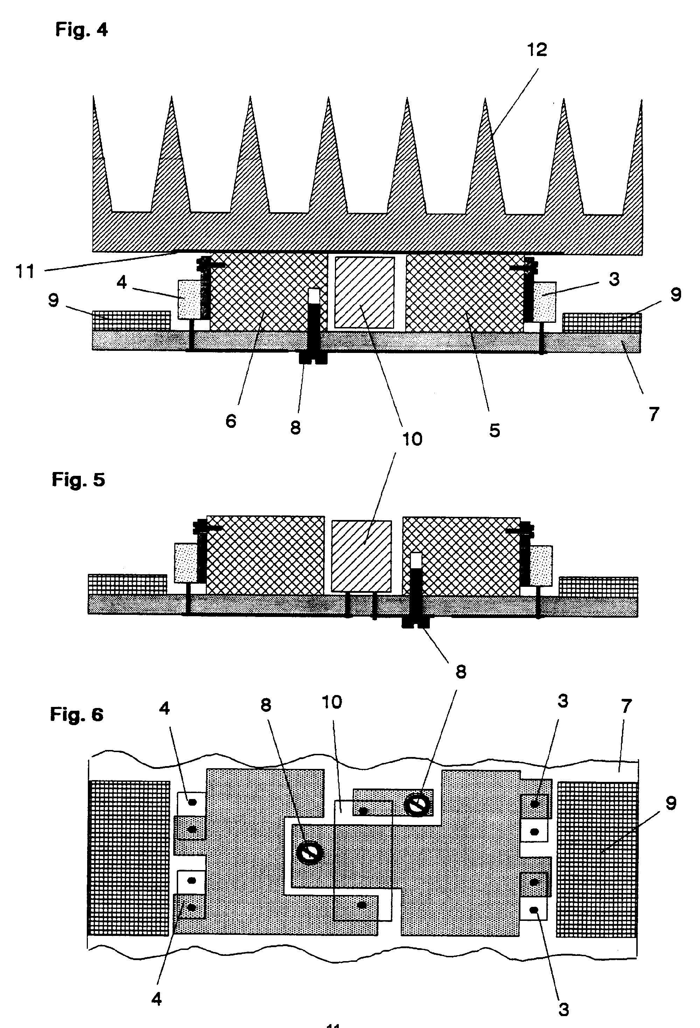

Fig. 4 zeigt eine andere Ausführung mit weiteren Vorteilen. Die ersten Ventile 3 sind elektrisch leitend an die Kühlschiene 5 und die zweiten Ventile 4 sind ebenfalls elektrisch leitend an die Kühlschiene 6 befestigt. Durch die Aufteilung der Kühlschiene wird auf der Oberseite zwischen den Kühlschienen 5 und 6 der Platine Raum für die Stützkondensatoren 10 geschaffen. Es wird hier nur noch eine einseitige Leiterplatte 7 benötigt, welche deutlich kostengünstiger ist. Die ohnehin vorhandenen Befestigungsschrauben 8 für die Montage der Kühlschienen 5 und 6 auf der Leiterplatte 7 dienen jetzt gleichzeitig der Stromführung. Der große Querschnitt der Kühlschienen 5 und 6 aus Aluminium schafft einen optimalen thermischen und ebenso elektrischen Gleichlauf. Die Kühlschiene 6 bildet den Mittenanschluß der Halbbrückenschaltung. Die Kühlschiene 5 kann als Anschluß des Pluspoles verwendet werden.

Die Oberseiten der beiden Kühlschienen 5 und 6 stellen als ebene Fläche eine optimale Wärmeschnittstelle dar, um für verschiedene Wärmeaufkommen flexible Lösungen realisieren zu können. Da beide Kühlschienen 5 und 6 unterschiedliches elektrisches Potential führen, muß an dieser Stelle eine wärmeleitende Isolierfolie 11 eingefügt werden. Der Kühlkörper 12 kann bei geringer Belastung eine ebene Platte sein und im anderen Fall ein handelsübliches Hochleistungsprofil mit ebenem Boden oder ein Kühlkanal mit Gebläse.

In einer weiteren vorteilhaften Ausgestaltung besitzen die Kühlschienen 5 und 6 Bohrungen zur Durchleitung eines Kühlmediums.

Die Fig. 4, 5 und 6 zeigen einen möglichen Leiterbahnverlauf bei einer einseitigen Leiterplatte. Aus der Fig. 4 sieht man, wie der Strom ausgehend von der als Plusschiene verwendeten ersten Kühlschiene 5 über die Kühlfläche zum Ventil 3 dann weiter über dessen Fuß auf die Kupferbahn der Leiterplatte 7 geführt wird. Von dort geht die Verbindung über das Befestigungsmittel 8 auf die zweite Kühlschiene 6 und über die Kühlfläche zum Ventil 4. Dessen Fuß führt zur Minus-Kupferbahn auf der Leiterplatte 7.

In Fig. 5 sieht man, wie der Stützkondensator 10 mit der Plus- und Minusseite verbunden ist.

Fig. 6 zeigt einen möglichen Leiterbahnverlauf in der Draufsicht, hier sieht man vor allem nochmals, wie der Stützkondensator 10 angeschlossen ist.

Ein weiterer Vorteil dieser erfindungsgemäßen mechanischen Anordnung liegt darin, daß anstelle der Transistoren handelsübliche pin-kompatible Dioden eingesetzt werden können. Damit können mit derselben Leiterplatte und mit derselben mechanischen Anordnung sowohl eine vollgesteuerte Halbbrückenschaltung als auch beide Varianten (Transistor oben und Diode unten oder emgekehrt) einer halbgesteuerten Halbbrückenschaltung aufgebaut werden. Die nicht benötigten Anschlüsse auf der Leiterplatte für die Ansteuerkreise bleiben dann unbestückt. Dies ist besonders wichtig, weil damit nur ein Platinentyp in die Fertigung eingeführt werden muß und die speziellen Prüfgeräte nur einmal benötigt werden.

## Patentansprüche

1. Elektronischer Leistungs-Schalter in Halbbrückenschaltung, der zwischen zwei Gleichspannungsanschlüssen eine Reihenschaltung von zwei Ventilgruppen (1,2) besitzt, und bei dem wenigstens eine Ventilgruppe aus einer Parallelschaltung von mehreren einzelnen gleichartigen Ventilen (3,4) geringerer Strombelastbarkeit besteht, bei dem alle Ventile beider Gruppen auf einer gemeinsamen Leiterplatte befestigt sind und bei dem die Ventile im Schaltbetrieb eingesetzt werden,
dadurch gekennzeichnet,
daß die ersten und die zweiten, parallel geschalteten Ventile (3,4) jeweils nebeneinander in einer Reihe an einer gemeinsamen Kühlschiene befestigt sind, wobei die ersten Ventile (3) elektrisch isoliert und die zweiten Ventile (4) elektrisch leitend mit der Kühlschiene verbunden sind,
daß die Kühlschiene den Mittelanschluß zwischen den ersten und den zweiten Ventilen (3 und 4) bildet,
daß der gesamte Laststrom über die Kupferlage(n) der Leiterplatte (7) geführt ist und
daß eine Leiterschleife aus den ersten Ventilen (3), den zweiten Ventilen (4) und Stützkondensatoren (10) real nur aus den diskreten Bauteilen mit ihren Anschlußdrähten, den Kupferlagen der Leiterplatte (7) und der gemeinsamen Kühlschiene besteht.

2. Elektronischer Leistungs-Schalter in Halbbrückenschaltung, der zwischen zwei Gleichspannungsanschlüssen eine Reihenschaltung von zwei Ventilgruppen (1,2) besitzt und bei dem wenigstens eine Ventilgruppe aus einer Parallelschaltung von mehreren einzelnen gleichartigen Ventilen (3,4) geringerer Strombelastbarkeit besteht, bei dem alle Ventile beider Gruppen auf einer gemeinsamen Leiterplatte (7) befestigt sind und bei dem die Ventile im Schaltbetrieb eingesetzt werden,
dadurch gekennzeichnet,
daß die ersten parallel geschalteten Ventile (3) nebeneinander in einer Reihe an einer gemeinsamen ersten Kühlschiene (5) befestigt sind und die zweiten parallel geschalteten Ventile (4) ebenfalls linear nebeneinander an einer gemeinsamen zweiten Kühlschiene (6) elektrisch leitend befestigt sind,
daß die elektrisch leitende zweite Kühlschiene (6) den Mittelanschluß zwischen den ersten und den zweiten Ventilen (3 und 4) bildet,
daß der gesamte Laststrom über die Kupferlage(n) der Leiterplatte (7) geführt ist, und
daß eine Leiterschleife aus den ersten Ventilen (3), den zweiten Ventilen (4) und Stützkondensatoren (10) real nur aus den diskreten Bauteilen mit ihren Anschlußdrähten, den Kupferlagen der Leiterplatte (7) und den Kühlschienen (5,6) mit ihren Befestigungsmitteln (8) besteht.

3. Elektronischer Leistungs-Schalter nach Anspruch 2,
dadurch gekennzeichnet,
daß die ersten Ventile (3) elektrisch isoliert und die zweiten Ventile (4) jeweils mit einem Anschluß elektrisch leitend mit der zugeordneten Kühlschiene (5 bzw. 6) verbunden sind.

4. Elektronischer Leistungs-Schalter nach Anspruch 2,
dadurch gekennzeichnet,
daß die beiden Kühlschienen (5,6) elektrisch isoliert, jedoch wärmeleitend mit einem weiteren Kühlkörper (12) verbunden sind, der mit den beiden parallel und im Abstand zueinander auf der Leiterplatte (7) befestigten Kühlschienen (5,6) in Verbindung steht.

5. Elektronischer Leistungs-Schalter nach Anspruch 2,
dadurch gekennzeichnet,
daß die Leiterplatte (7) nur eine Kupferlage aufweist, und daß die elektrisch leitenden Befestigungsmittel (8) die Kühlschienen (5,6) mit der Leiterplatte (7) verbinden.

6. Elektronischer Leistungs-Schalter nach einem der Ansprüche 2, 3 und 4,
dadurch gekennzeichnet,
daß zwischen den beiden Kühlschienen (5,6) die Stützkondensatoren (10) angeordnet sind.

7. Elektronischer Leistungs-Schalter nach Anspruch 1,
dadurch gekennzeichnet,
daß die gemeinsame Kühlschiene (6) mit Kühlrippen versehen ist.

8. Elektronischer Leistungs-Schalter nach einem der Ansprüche 1 bis 7, dadurch gekennzeichnet,
daß die Ventile (3,4) Dioden, Transistoren, Thyristoren oder andere Leistungs-Halbleiterbauelemente sowie Kombinationen derselben sind.

9. Elektronischer Leistungs-Schalter nach einem der Ansprüche 1 bis 8, dadurch gekennzeichnet,
daß auf der Leiterplatte (7) den Ventilen (3,4) benachbart die Ansteuerschaltkreise (9) und erforderlichenfalls Versorgungs-bzw. Kontrollschaltkreise zur Beeinflussung bzw. Kontrolle der Ventile (3,4) aufgebracht sind.

10. Elektronischer Leistungs-Schalter nach einem der Ansprüche 1 bis 9, dadurch gekennzeichnet,
daß die gemeinsame Kühlschiene, die beiden Kühlschienen (5,6) und/oder der Kühlkörper (12) Kanäle für den Durchlaß eines Kühlmediums aufweisen.

## Claims

1. Electronic power switch in a half-bridge circuit, which switch includes a series connection of two rectifier groups (1, 2) between two D.C. connections, and wherein at least one rectifier group comprises a parallel connection of a plurality of individual, similar rectifiers (3, 4) having a relatively low current carrying capacity, wherein all of the rectifiers of both groups are mounted on a common printed circuit board, and wherein the rectifiers are utilised in the switching operation, characterised in that the first and the second rectifiers (3, 4), which second rectifiers are connected in parallel, are each mounted on a common cooling rail adjacent one another in series, the first rectifiers (3) being connected to the cooling rail in an electrically insulated manner, and the second rectifiers (4) being connected to the cooling rail in an electrically conductive manner, in that the cooling rail forms the central connection between the first and second rectifiers (3 and 4), in that the entire load current is conducted over the copper layer(s) of the printed circuit board (7), and in that a conductor loop, formed from the first rectifiers (3), the second rectifiers (4) and supporting capacitors (10), substantially only comprises the discrete components together with their connecting wires, the copper layers of the printed circuit board (7) and the common cooling rail.

2. Electronic power switch in a half-bridge circuit, which switch includes a series connection of two rectifier groups (1, 2) between two D.C. connections, and wherein at least one rectifier group comprises a parallel connection of a plurality of individual, similar rectifiers (3, 4) having a relatively low current carrying capacity, wherein all of the rectifiers of both groups are mounted on a common printed circuit board (7), and wherein the rectifiers are utilised in the switching operation, characterised in that the first rectifiers (3), which are connected in parallel, are mounted on a common first cooling rail (5) adjacent one another in series, and the second rectifiers (4), which are connected in parallel, are likewise linearly mounted adjacent one another on a common second cooling rail (6) in an electrically conductive manner, in that the electrically conductive second cooling rail (6) forms the central connection between the first and second rectifiers (3 and 4), in that the entire load current is conducted over the copper layer(s) of the printed circuit board (7), and in that a conductor loop, formed from the first rectifiers (3), the second rectifiers (4) and supporting capacitors (10), substantially only comprises the discrete components together with their connecting wires, the copper layers of the printed circuit board (7) and the cooling rails (5, 6) with their securing means (8).

3. Electronic power switch according to claim 2, characterised in that the first rectifiers (3) are connected to the associated cooling rail (5 or 6 respectively) in an electrically insulated manner, and the second rectifiers (4) are each connected to the associated cooling rail (5 or 6 respectively) in an electrically conductive manner by means of a connection.

4. Electronic power switch according to claim 2, characterised in that the two cooling rails (5, 6) are connected to an additional cooling body (12) in an electrically insulated, but thermally conductive manner, which cooling body communicates with the two cooling rails (5, 6) mounted on the printed circuit board (7) parallel to each other and at a spacing from each other.

5. Electronic power switch according to claim 2, characterised in that the printed circuit board (7) has only one copper layer, and in that the electrically conductive securing means (8) connect the cooling rails (5, 6) to the printed circuit board (7).

6. Electronic power switch according to one of claims 2, 3 and 4, characterised in that the supporting capacitors (10) are disposed between the two cooling rails (5, 6).

7. Electronic power switch according to claim 1, characterised in that the common cooling rail (6) is provided with cooling ribs.

8. Electronic power switch according to one of claims 1 to 7, characterised in that the rectifiers (3, 4) are diodes, transistors, thyristors or other semiconductor power components and combinations thereof.

9. Electronic power switch according to one of claims 1 to 8, characterised in that the actuation circuits (9), and if necessary supply and/or control circuits for influencing or controlling the rectifiers (3, 4), are mounted on the printed circuit board (7) adjacent the rectifiers (3, 4).

10. Electronic power switch according to one of claims 1 to 9, characterised in that the common cooling rail, the two cooling rails (5, 6) and/or the cooling body (12) have channels for a cooling medium to pass therethrough.

## Revendications

1. Commutateur électronique de puissance en montage en demi-pont, qui entre deux bornes courant continu possède un circuit en série de deux groupes de valves (1, 2), et dans lequel au moins un groupe de valves est constitué par un circuit en parallèle de plusieurs valves individuelles de même nature (3, 4) ne pouvant être soumises qu'à une intensité électrique moindre, dans lequel toutes les valves des deux groupes sont fixées sur une plaque conductrice commune et dans lequel les valves sont utilisées en service de commutation,
caractérisé par le fait
que les premières et les deuxièmes valves couplées en parallèle (3, 4) sont chacune fixées côte à côte dans une rangée sur une barre de refroidissement commune, les premières valves (3) étant isolées électriquement et les deuxièmes valves (4) étant connectées à conductivité électrique à la barre de refroidissement,
que la barre de refroidissement constitue la borne médiane entre les premières et les deuxièmes valves (3 et 4),
que le courant de charge total est transmis par la (les) couche(s) de cuivre de la plaque conductrice (7) et
qu'une boucle de conducteur composée des premières valves (3), des deuxièmes valves (4) et des condensateurs de support (10) est constituée réellement uniquement des éléments de construction discrets avec leurs fils de connexion, les couches de cuivre de la plaque conductrice (7) et la barre de refroidissement commune.

2. Commutateur électronique de puissance en montage en demi-pont, qui entre deux bornes courant continu possède un circuit en série de deux groupes de valves (1, 2), et dans lequel au moins un groupe de valves est constitué par un circuit en parallèle de plusieurs valves individuelles de même nature (3, 4) ne pouvant être soumises qu'à une intensité électrique moindre, dans lequel toutes les valves des deux groupes sont fixées sur une plaque conductrice commune (7) et dans lequel les valves sont utilisées en service de commutation,
caractérisé par le fait
que les premières valves couplées en parallèle (3) sont fixées côte à côte dans une rangée sur une première barre de refroidissement commune (5) et que les deuxièmes valves couplées en parallèle (4) sont également fixées linéairement côte à côte à conductivité électrique sur une deuxième barre de refroidissement commune (6),
que la deuxième barre de refroidissement (6) à conductivité électrique constitue la borne médiane entre les premières et les deuxièmes valves (3 et 4),
que la totalité du courant de charge est transmis par la ou les couches de cuivre de la plaque conductrice (7), et
qu'une boucle de conducteur composée des premières valves (3), des deuxièmes valves (4) et des condensateurs de support (10) est constituée réellement uniquement des éléments de construction discrets avec leurs fils de connexion, les couches de cuivre de la plaque conductrice (7) et les barres de refroidissement (5, 6) avec leurs moyens de fixation (8).

3. Commutateur électronique de puissance suivant la revendication 2,
caractérisé par le fait
que les premières valves (3) sont reliées avec isolement électrique à la barre de refroidissement associée( 5 ou 6) et que les deuxièmes valves (4) sont chacune reliées par une borne à conductivité électrique à la barre de refroidissement associée ( 5 ou 6).

4. Commutateur électronique de puissance suivant la revendication 2,
caractérisé par le fait
que les deux barres de refroidissement (5, 6) sont reliées de manière isolée électriquement mais à conductivité thermique à un organe de refroidissement supplémentaire (12), lequel est en liaison avec les deux barres de refroidissement (5, 6) fixées parallèlement et à distance l'une de l'autre sur la plaque conductrice (7).

5. Commutateur électronique de puissance suivant la revendication 2,
caractérisé par le fait
que la plaque conductrice (7) présente une seule couche de cuivre, et que les moyens de fixation (8) à conductivité électrique relient les barres de refroidissement (5, 6) à la plaque conductrice (7).

6. Commutateur électronique de puissance suivant l'une quelconque des revendications 2, 3 et 4,
caractérisé par le fait
qu'entre les deux barres de refroidissement (5, 6) sont disposés les condensateurs de support (10).

7. Commutateur électronique de puissance suivant la revendication 1,
caractérisé par le fait
que la barre de refroidissement commune (6) est dotée d'ailettes de refroidissement.

8. Commutateur électronique de puissance suivant l'une quelconque des revendications de 1 à 7,
caractérisé par le fait
que les valves (3, 4) sont des diodes, des transistors, des thyristors ou d'autres éléments semi-conducteurs de puissance ainsi que des combinaisons de ces éléments.

9. Commutateur électronique de puissance suivant l'une quelconque des revendications de 1 à 8,
caractérisé par le fait
que sur la plaque conductrice (7), au voisinage des valves (3, 4), sont montés les circuits de commande (9) et le cas échéant les circuits d'alimentation ou de contrôle pour influencer les valves (3, 4) ou pour leur contrôle.

10. Commutateur électronique de puissance suivant l'une quelconque des revendications de 1 à 9,
caractérisé par le fait
que la barre de refroidissement commune, les deux barres de refroidissement (5, 6) et/ou l'organe de refroidissement (12) présentent des canalisations pour le passage d'un fluide de refroidissement.
